# EUROPEAN PATENT APPLICATION

(11) **EP 3 288 100 A1**
(43) Date of publication of application: **28.02.2018**
(21) Application number: 17184114.1
(22) Date of filing: 31.07.2017
(51) Int. Cl.: H01M 2/10

(54) **STACKED ELECTRIC POWER MODULES WITH SLIDING STRUCTURES**

(30) Priority: 25.08.2016 TW 105213128 U
(71) Applicant: Formosa Electronic Industries Inc., New Taipei City 23144 (TW)
(72) Inventor: YANG, Kuo-Shun, 24458 New Taipei City (TW)
(74) Representative: Karakatsanis, Georgios

(57) **Abstract**

A sliding structure for stacked electric power modules (1) is provided. The sliding structure includes a left slide structure (41) and a right slide structure (42) extending in a movement direction (M1) at a left top edge and a right top edge of the electric power module (1) respectively. A left bottom edge and a right bottom edge of each electric power module (1) are respectively provided with a counterpart left slide structure (51) and a counterpart right slide structure (52) extending in the movement direction (M1) and corresponding to the left slide structure (41) and the right slide structure (42) respectively. Multiple electric power modules (1) are allowed to be stacked through the sliding structure.

## Description

### BACKGROUND OF THE INVENTION

### 1. Field of the Invention

The present invention relates to a stacked structure for electric power modules, and in particular to a slide-to-stack structure for stacking electric power modules.

### 2. The Related Arts

Electric power modules have been widely used in various electric appliances for storage of electric power and supply of the stored electric power. For combination of multiple electric power modules, a conventional arrangement of electric power modules comprises a metal housing that surrounds a frame or a box structure and a battery pack is then deposited and fixed inside the frame or the box by means of locks, such as bolts, retention bars, retention tabs, and rivets, and is then connected with a connector or a connection cable. Such a conventional arrangement has several drawbacks, such as being hard to assemble, being difficult to disassemble and maintain, and high material costs for the frame.

Further, to remove heat generated during the operation of the electric power modules, it is often to provide a heat dissipation fan inside the frame or box. This would include additional cost of heat dissipation and also causes additional issues of maintenance and operation noise.

### SUMMARY OF THE INVENTION

An objective of the present invention is to provide a sliding structure for stacked electric power modules, which allows multiple electric power modules to be stacked through simple slide-to-stack structure and easy operation.

The present invention provides a sliding structure for stacked electric power modules. The sliding structure includes a left slide structure and a right slide structure extending in a movement direction at a left top edge and a right top edge of the electric power module respectively. A left bottom edge and a right bottom edge of each electric power module are respectively provided with a counterpart left slide structure and a counterpart right slide structure extending in the movement direction and corresponding to the left slide structure and the right slide structure respectively. Multiple electric power modules are allowed to be stacked through the sliding structure.

An objective of the present invention is to provide a sliding structure for stacked electric power modules, which allows multiple electric power modules to be stacked through simple slide-to-stack structure and easy operation.

The sliding structure for stacked electric power modules according to the present invention allows multiple electric power modules to be stacked through a simple slide-to-stack structure and an easy operation, without need of complicated structure. Further, the heat generated during the operation of the electric power module may be dissipated through a heat dissipation fin assembly and a coolant liquid channel formed on the electric power module.

### BRIEF DESCRIPTION OF THE DRAWINGS

The present invention will be apparent to those skilled in the art by reading the following description of preferred embodiments of the present invention, with reference to the attached drawings, in which:
FIG. 1 is a perspective view showing an embodiment of the present invention;
FIG. 2 is an exploded view of FIG. 1 with parts being detached;
FIG. 3 is a top plan view of FIG. 2;
FIG. 4 is an exploded view of the present invention, taken from the rear side, with parts being detached;
FIG. 5 is a cross-sectional view taken along line 5-5 of FIG. 1;
FIG. 6 is an exploded view of the present invention with parts being further detached;
FIG. 7 is a perspective view, taken from a front side, illustrating multiple electric power modules being stacked and combined together according to the present invention;
FIG. 8 is a right side view illustrating multiple electric power modules being stacked through a sliding operation according to the present invention;
FIG. 9 is a perspective view, taken from a front side, illustrating that multiple electric power modules have been stacked according to the present invention;
FIG. 10 is a right side view illustrating that multiple electric power modules have been stacked according to the present invention; and
FIG. 11 is a perspective view, taken from a rear side, illustrating that multiple electric power modules have been stacked according to the present invention.

### DETAILED DESCRIPTION OF THE PREFERRED EMBODIMENTS

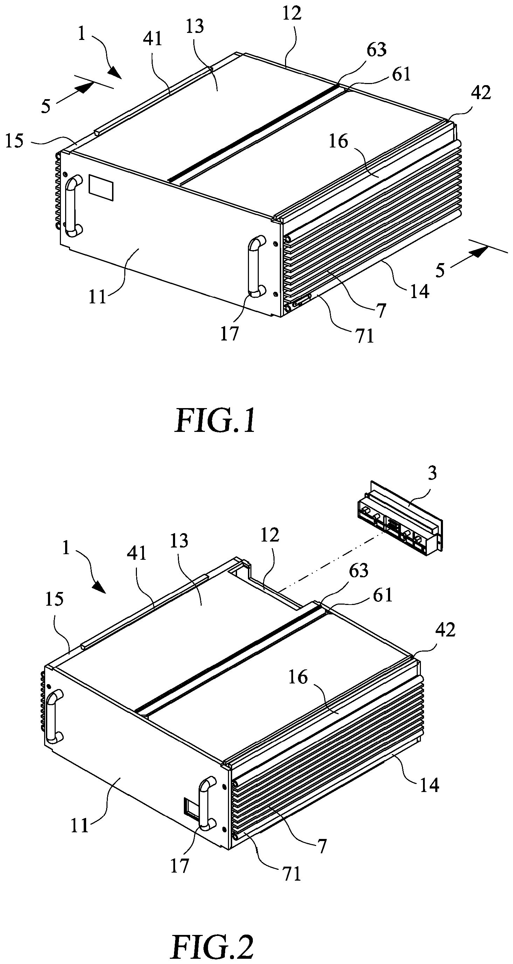

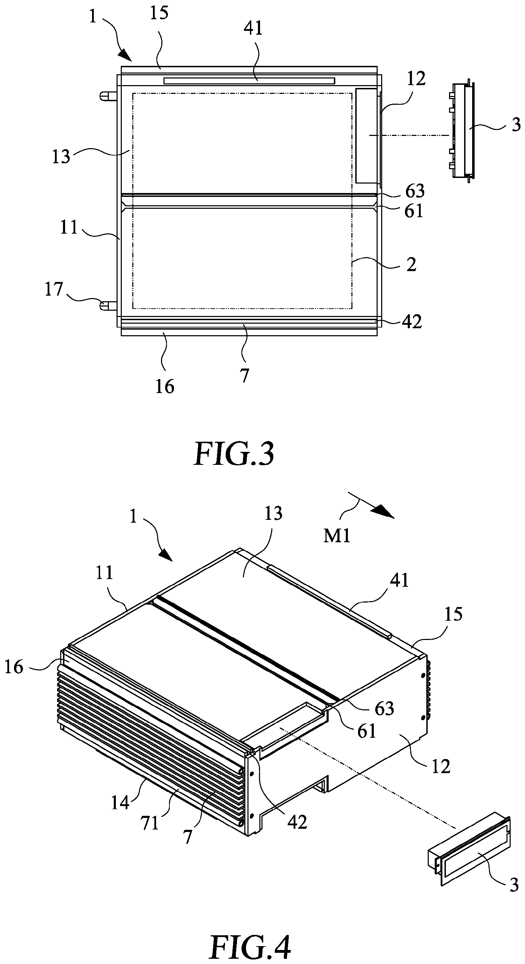

Referring to FIGs. 1-4, FIG. 1 is a perspective view, taken from a front side, showing an embodiment of the present invention; FIG. 2 is an exploded view of FIG. 1, taken from the front side, with parts being detached; FIG. 3 is a top plan view of FIG. 2; and FIG. 4 is an exploded view of the present invention, taken from the rear side, with parts being detached.

As shown in the drawings, an electric power module 1 comprises an interior space defined among and by a front board 11, a back board 12, a top board 13, a bottom board 14, and a left side board 15 and a right side board 16 that are opposite to each other. A battery pack 2 is received and fixed in the interior space of the electric power module 1. The front board 11 of the electric power module 1 comprises two handles 17 mounted thereto to allow for easy operation by a user for sliding of the electric power module 1.

The back board 12 of the electric power module 1 is provided with a connector module 3 at a location adjacent to the top board 13. The connector module 3 is electrically connected with the battery pack 2. The connector module 3 may include at least one power connector and at least one signal connector.

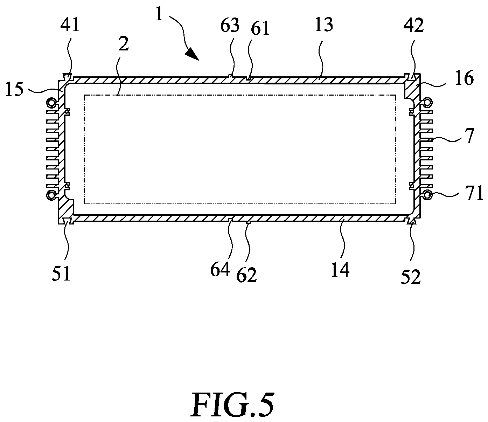

Referring also to FIG. 5, the top board 13 of the electric power module 1 is provided, on a left top edge and a right top edge thereof, with a left slide structure 41 and a right slide structure 42 that extend in a movement direction M1.

The bottom board 14 of the electric power module 1 is provided, on a left bottom edge and a right bottom edge thereof, with a counterpart left slide structure 51 and a counterpart right slide structure 52 that extend in the movement direction M1 and respectively correspond to the left top edge 41 and the right top edge 42.

With the structural arrangement involving the left slide structure 41, the right slide structure 42, the counterpart left slide structure 51, and the counterpart right slide structure 52, more than two electric power modules 1 can be combined together by being stacked sequentially over each other and connection made between the connector modules 3 and the counterpart insertion receptacle assemblies 3a thereof allows for formation of an expanded, large-sized electric power module. In the embodiment of the present invention, the left slide structure 41, the right slide structure 42, the counterpart left slide structure 51, and the counterpart right slide structure 52 can be a slide structure involving dovetailed structures that correspond to and mate each other or any other corresponding and mated structures for sliding movement, such as guide rail and mating guide slot.

The top board 13 of the electric power module 1 is further formed with an alignment slot 61 extending in the movement direction M1. The bottom board 14 of the electric power module 1 is further formed with an alignment rail 62 that extends in the movement direction M1 and corresponds to the alignment slot 61. The top board 13 is additionally provided with an ancillary rail 63 formed thereon at a location adjacent to the alignment slot 61; and the bottom board 14 is additionally provided with an ancillary slot 64 formed therein at a location adjacent to the alignment rail 62.

The left side board 15 and the right side board 16 of the electric power module 1 are each formed with a heat dissipation fin assembly 7 to provide excellent heat dissipation to the electric power module 1. Further, the heat dissipation fin assembly 7 is provided with at least one coolant liquid channel 71, which is connected with piping (not shown) and receives coolant liquid supplied into the coolant liquid channel 71 to provide an improved effect of heat dissipation.

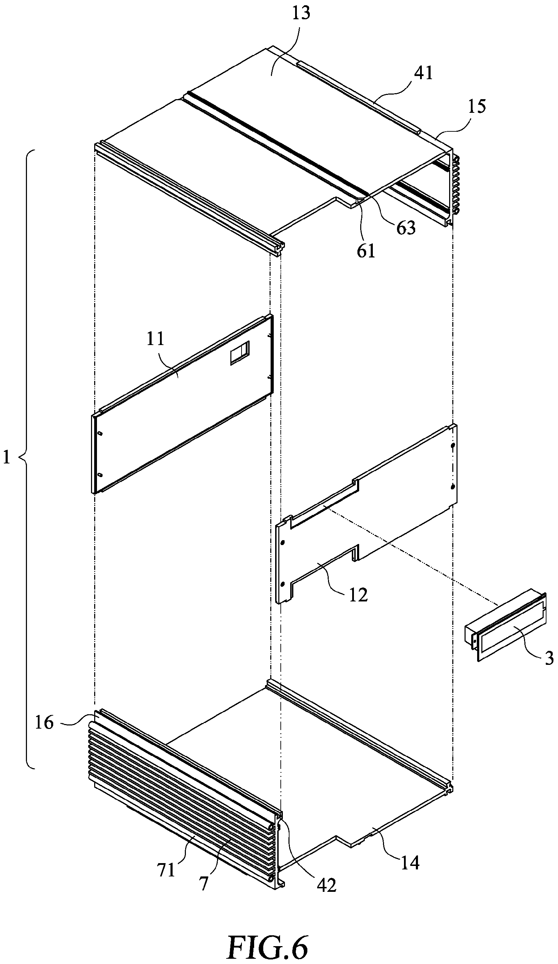

FIG. 6 is an exploded view of the present invention with parts being further detached. As shown in FIG. 6, the top board 13, the bottom board 14, the left side board 15, and the right side board 16 are preferably formed by integrating molding.

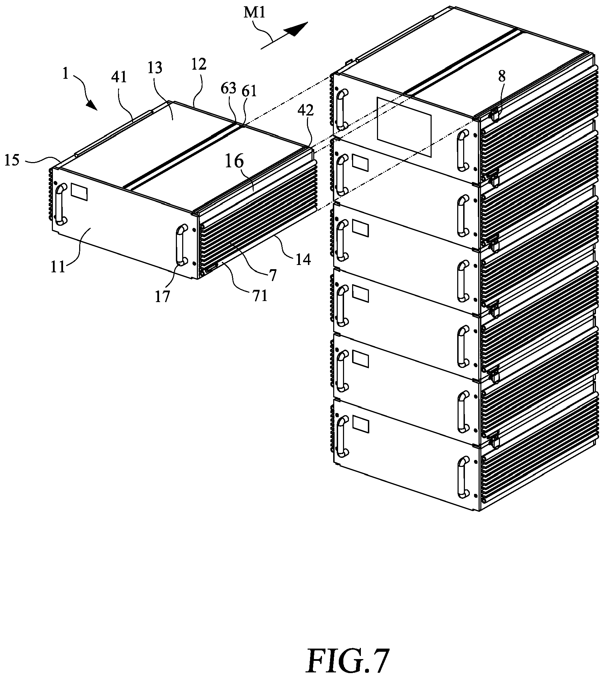

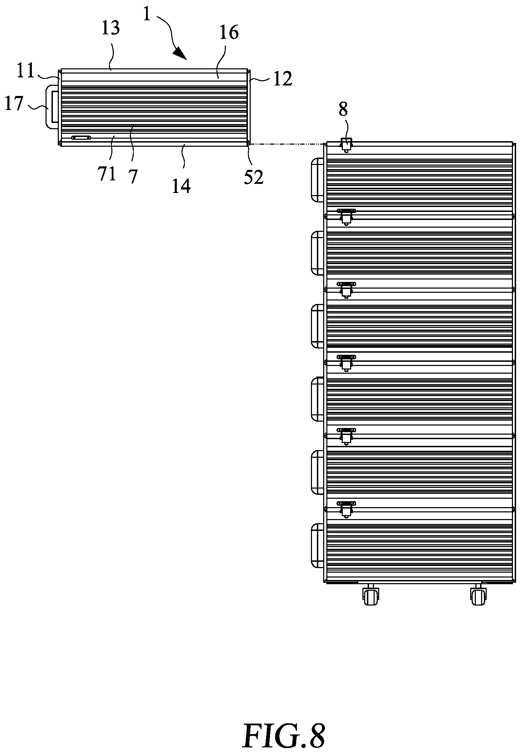

FIG. 7 is a perspective view, taken from a front side, illustrating multiple electric power modules 1 being stacked and combined together according to the present invention. FIG. 8 is a right side view illustrating multiple electric power modules 1 being stacked through a sliding operation according to the present invention.

To stack an additional, upper-side electric power module, which has the same structure, on the electric power module 1 in a manner of being vertically adjacent to each other, a counterpart left slide structure and a counterpart right slide structure of the upper-side electric power module are respectively brought into alignment the left slide structure 41 and the right slide structure 42 of the electric power module 1 and a movement is made in the movement direction M1 such that the upper-side electric power module is coupled, through the sliding movement, to the top board 13 of the electric power module 1.

The bottom board 14 of the electric power module 1 is also combinable with a lower-side electric power module that has the same structure. To combine and couple together the electric power module 1 and the lower-side electric power module, a left slide structure and a right slide structure of the lower-side electric power module are respectively brought into alignment with the counterpart left slide structure 51 and the counterpart right slide structure 52 of the electric power module 1 and a movement is made in the movement direction M1 such that the lower-side electric power module is stacked under and coupled to the bottom board 14 of the electric power module 1.

The stacked combination of the electric power module 1 with the adjacent modules is achieved through alignment between the alignment slot 61 and the alignment rail 62, as well as the ancillary rail 63 and the ancillary slot 64, in order to provide an effect of guiding for the sliding movement.

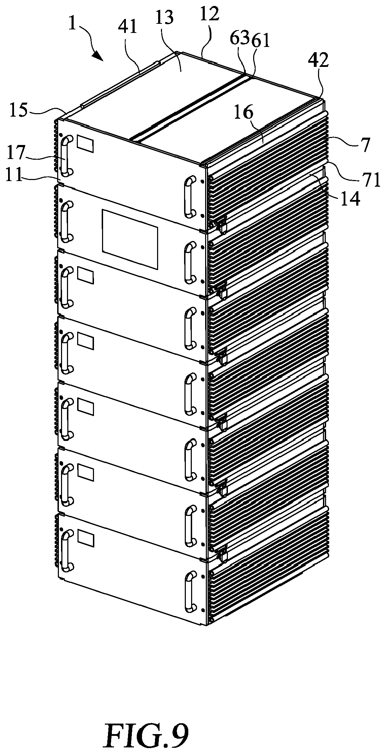

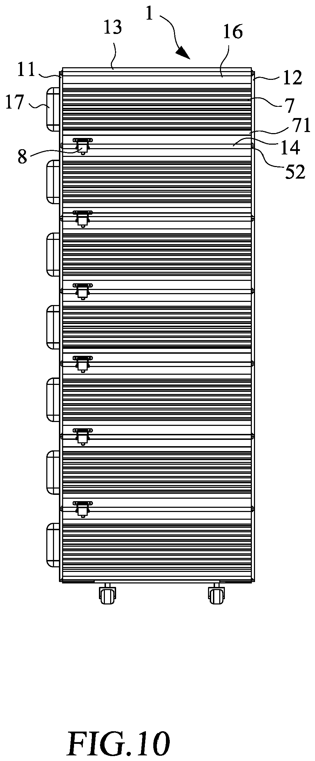

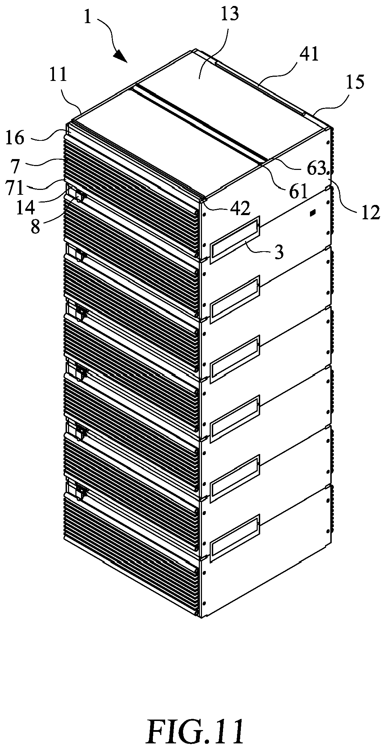

FIG. 9 is a perspective view, taken from a front side, illustrating that multiple electric power modules 1 have been stacked according to the present invention. FIG. 10 is a right side view illustrating that multiple electric power modules have been stacked according to the present invention. FIG. 11 is a perspective view, taken from a rear side, illustrating that multiple electric power modules have been stacked according to the present invention.

After the electric power modules have been combined through the sliding movements, a lock 8, which is provided on the left side board 15 and the right side board 16, may be applied to securely lock together the electric power modules that are vertically adjacent to each other.

Although the present invention has been described with reference to the preferred embodiments thereof, it is apparent to those skilled in the art that a variety of modifications and changes may be made without departing from the scope of the present invention which is intended to be defined by the appended claims.

## Claims

1. A sliding structure for stacked electric power modules (1), wherein each of the electric power modules (1) is provided with an interior space defined among and by a front board (11), a back board (12), a top board (13), a bottom board (14), a left side board (15), and a right side board (16), a battery pack (2) being contained in the interior space of the electric power module (1), the top board (13) having a left top edge (41) and a right top edge (42), the bottom board (14) having a left bottom edge (51) and a right bottom edge (52), the back board (12) being mounted with a connector module (3) and electrically connected with the battery pack (2), **characterized in that** the sliding structure comprises:
a left slide structure (41) and a right slide structure (42) extending in a movement direction (M1), are formed on the left top edge and the right top edge of each electric power module (1) respectively; and
a counterpart left slide structure (51) and a counterpart right slide structure (52) extending in the movement direction (M1) and corresponding to the left slide structure (41) and the right slide structure (42) respectively, are formed on the left bottom edge and the right bottom edge of each electric power module (1), so that multiple electric power modules (1) are allowed to be stacked through the sliding structure.

2. The sliding structure as claimed in Claim 1, wherein the top board (13) of the electric power module (1) further comprises an alignment slot (61) formed therein and extending in the movement direction (M1) and the bottom board (14) of the electric power module (1) comprises an alignment rail (62) corresponding to the alignment slot (61) of the top board (13).

3. The sliding structure as claimed in Claim 1, wherein the left side board (15) and the right side board (16) of the electric power module (1) are provided with a heat dissipation fin assembly (7) respectively.

4. The sliding structure as claimed in Claim 1, wherein the left side board (15) and the right side board (16) of the electric power module (1) are each provided with at least one coolant liquid channel (71) formed thereon.

5. The sliding structure as claimed in Claim 1, wherein the top board (13), the bottom board (14), the left side board (15), and the right side board (16) are formed by integrating molding.

6. The sliding structure as claimed in Claim 1, wherein the left side board (15) and the right side board (16) of the electric power module (1) are each provided with a lock (8).
